Europäisches Patentamt

European Patent Office

Office européen des brevets

(11) Publication number: **0 285 264**
**A2**

# EUROPEAN PATENT APPLICATION

(21) Application number: 88301830.1

(22) Date of filing: 02.03.88

(51) Int. Cl.⁴: **G06F 15/60**

(30) Priority: 02.04.87 US 33290

(43) Date of publication of application:
05.10.88 Bulletin 88/40

(84) Designated Contracting States:
**DE FR GB**

(71) Applicant: **TEKTRONIX, INC.**
**Howard Vollum Park 14150 S.W. Karl Braun**
**Drive P.O. Box 500**
**Beaverton Oregon 97077(US)**

(72) Inventor: **Blanks, John P.**
**4017 S.W. Fairvale Drive**
**Portland Oregon 97221(US)**

(74) Representative: **Wombwell, Francis et al**
**Potts, Kerr & Co. 15, Hamilton Square**
**Birkenhead Merseyside L41 6BR(GB)**

(54) **A method of placing blocks on a carrier.**

(57) An initial placement of blocks on a carrier is tested in order to determine whether the placement can be improved by interchanging a first block and a second block by first selecting a terminal of the first block and identifying blocks that are connected to that terminal of the first block. A measure of the half-perimeter of a rectangle bounding the positions on the carrier of the first block and the blocks identified as being connected to the first block is computed, and a measure of the half-perimeter of a second rectangle bounding the positions on the carrier of the second block and the blocks identified as being connected to the first block is computed. The half-perimeter of the second rectangle is subtracted from the half-perimeter of the first rectangle to yield a difference value. These steps are carried out for all other terminals of the first block and for the second block. The sum of the difference values for the first block is added to the sum of the difference values for the second block to yield a test score. If the test score is negative, the placement is modified by interchanging the first block and the second block.

FIG.1

EP 0 285 264 A2

# A METHOD OF PLACING BLOCKS ON A CARRIER

This invention relates to a method of placing blocks on a carrier, and in particular to testing a possible interchange of two blocks in order to determine whether the placement can be improved.

## Background of the Invention

The application of computer-aides design (CAD) to fabrication of an integrated circuit employing multiple functionally distinct circuit blocks, such as standard cells and gate arrays, has two major stages - system design and implementation. In the system design stage, the blocks that are to be used are selected and the connections that are required among the terminals of the blocks are defined. The wiring connections that are made to a terminal or pin of a block are known as a net. A given net is normally connected to terminals of several blocks. Generally, a given block has several terminals and separate nets are connected to the terminals respectively. Data defining various attributes of the blocks, including the shape and size of each block, the locations of terminals of the block, and the connections that are required among the terminals of the blocks, is specified to a CAD system. Implementation is concerned with using the CAD system to bring the product of the system design stage to practical application.

Implementation itself has several phases. First, knowing the sizes and shapes of the blocks, a placement phase takes place. In the placement phase, data base files are created in which locations of the blocks on the integrated circuit die are defined such that there are no overlaps of blocks and economical use is made of the die area. Open spaces between blocks are reserved for channels to accommodate wiring connections among the terminals. After the placement phase is complete, a global routing phase takes place. In the global routing phase, the connections among the terminals are assigned to specific channels and the data base files are updated with data reflecting these channel assignments. The precise route that a connection takes through a channel is thereafter defined in a detail routing phase, and the data base files are updated accordingly. In the detail routing phase, minor adjustments in the placement of the blocks might be made. At the end of the detail routing phase, the data base files of the CAD system contain information defining the positions of the blocks on the die, the positions of the terminals of the blocks, and the paths followed by the connections among the blocks. These data base files are used when making the masks that are used in fabrication of the integrated circuit.

In order to maintain the volume of data to be stored and processed within manageable limits, the CAD system requires that all features that are defined in a plane parallel to the surface of the die be oriented along one of two orthogonal directions, normally referred to the horizontal or X direction and the vertical or Y direction.

The success with which a CAD system may be used to aid in fabrication of an integrated circuit depends at a first level on being able to complete the design and this in turn depends upon the CAD system's being able to route all the connections that are defined in the system design stage within the channels that are defined in the placement phase. At a second level, the success depends on minimizing the total length of wire necessary to complete the connections. Minimization of wire length is desirable in the case of an integrated circuit employing standard cells, because this implies that the size of the die is minimized, and is desirable in the case of an integrated circuit employing gate arrays because it implies that more space is available on the die for providing connections. Therefore, it is desirable to test the placement of the blocks on the die to determine whether it can be modified in a manner such that the total wire length is reduced. Accordingly, the placement phase is typically performed in two parts, namely constructive initial placement and iterative improvement placement.

Constructive initial placement begins with all or some of the blocks unplaced and determines an initial or trial location for each block on the carrier. In constructive initial placement, a placement slot is associated with each block. Each slot is defined with respect to both its position on the carrier and its size.

In each step of iterative improvement placement, a pair of blocks are interchanged between their respective placement slots, and a determination is made as to whether the new placement is better than the previous placement, i.e. results in a reduction in total wire length. If the new placement is not better than the previous placement, it is rejected and the blocks are returned to the slots that they occupied before the interchange. If, on the other hand, the new placement is better than the previous placement, the new placement is adopted and becomes the previous placement for the next interchange. The use of placement slots for receiving blocks limits the interchanges that are considered to those which avoid overlap of blocks and other problems.

In order to determine whether a new placement is better than the previous placement, it would in principle be possible to determine whether the total wire length for the new placement is less than the total wire length for the previous placement. However, this would require carrying out global and detail routing for each placement and this is impractical. Accordingly, it has become conventional to adopt a scoring metric for judging the quality of a placement without carrying out global and detail routing.

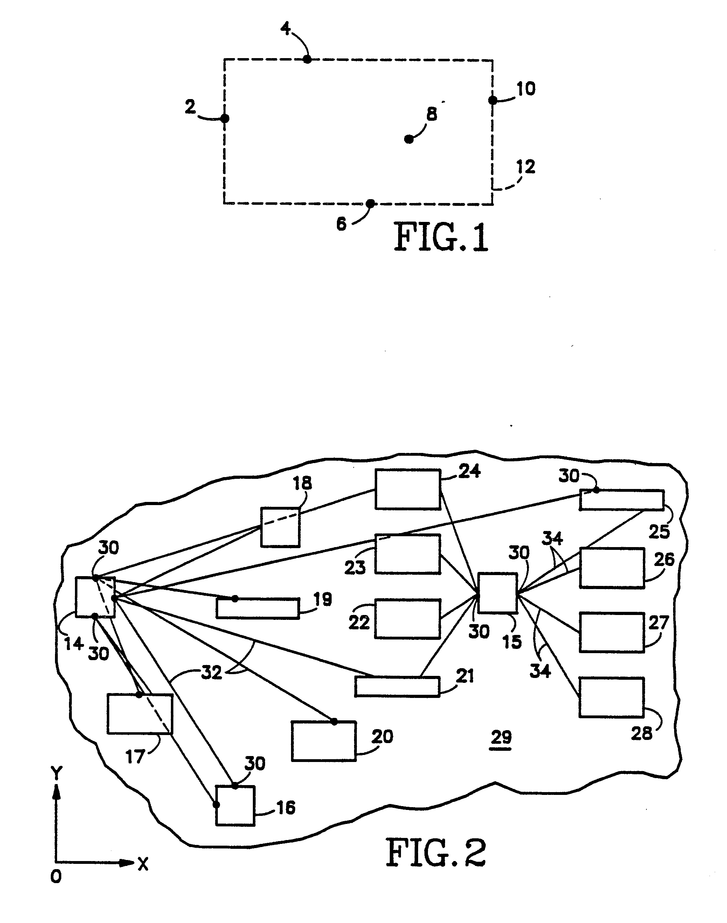

A known scoring metric is the net half-perimeter metric. In FIG. 1, terminals 2, 4, 6, 8 and 10, which are connected by a net, are illustrated. The net half-perimeter, or NHP, for a given net is defined as the sum of the horizontal and vertical extents of the bounding rectangle 12 of that net.

To avoid confusion, the term "NHP" is used hereafter by itself to designate the net half-perimeter for a single net in a particular placement, the term "block NHP" is used to designate the sum of the NHPs for all nets with terminals on a particular block in a particular placement, and the term "placement NHP" is used to designate the sum of all the NHPs for all the nets in a particular placement. Assuming that at least one net has terminals on more than one block, the placement NHP is not equal to the sum of the block NHPs.

In order to determine whether a new placement is better than the previous placement with regard to the net half-perimeter metric, it is necessary to know whether the placement NHP for the new placement is less than the placement NHP for the previous placement. However, it is not necessary to compute the placement NHP before the interchange and the placement NHP after the interchange, since the NHPs of nets that do not belong to the two blocks selected for possible interchange will not be affected by the interchange. Therefore, in order to determine the change in placement NHP that will result from a possible interchange, it is only necessary to compute the block NHPs for the two selected blocks, both before and after the interchange.

Hitherto, iterative improvement placement employing the net half-perimeter metric has involved selecting two interchangeable blocks, computing the block NHP for the selected blocks before the interchange, i.e. in the current placement, and computing the block NHP for the selected blocks after the interchange. If the sum of the two block NHPs after the interchange is less than sum of the two block NHPs before the interchange, the interchange is accepted; otherwise it is rejected. This procedure involves a large amount of computation, and is therefore time consuming and expensive to carry out.

## Summary of the Invention

In a preferred embodiment of the invention, an initial placement of blocks on a carrier is tested in order to determine whether the placement can be improved by interchanging a first block and a second block by first selecting a terminal of the first block and identifying blocks that are connected to that terminal of the first block. A measure of the half-perimeter of a rectangle bounding the positions on the carrier of the first block and the blocks identified as being connected to the first block is computed, and a measure of the half-perimeter of a second rectangle bounding the positions on the carrier of the second block and the blocks identified as being connected to the first block is computed. The half-perimeter of the second rectangle is substracted from the half-perimeter of the first rectangle to yield a difference value. These steps are carried out for all other terminals of the first block and for the second block. The sum of the difference values for the first block is added to the sum of the difference values for the second block to yield a test score. If the test score is negative, the placement is modified by interchanging the first block and the second block.

## Brief Description of the Drawings

For a better understanding of the invention and to show how the same may be carried into effect, reference will now be made, by way of example, to the accompanying drawings in which:

FIG. 1 is a plan view of terminals on a carrier, to illustrate the concept of the net half-perimeter metric,

FIG. 2 is a plan view of blocks on a carrier, and illustrates the nets belonging to two blocks that have been selected for possible interchange,

FIGS. 3 and 4 illustrate separately the nets belonging to the two selected blocks,

FIG. 5 is a modification of FIG. 3(c) for illustrating an approximation for the NHP of the net shown in FIG. 3(c),

FIG. 6 is a view similar to FIG. 5, illustrating the manner in which a function relating the NHP of a net to the position of one block is developed,

FIG. 7 is a plan view of terminals for illustrating a step in the method described with reference to FIG. 6, and

FIG. 8 is a block diagram of a CAD system for carrying out the method described with reference to FIG. 6.

## Detailed Description

FIG. 2 illustrates several blocks 14 . . . 28 disposed on a carrier 29. The blocks might be standard integrated circuit cells and the carrier might be an integrated circuit die. Each block is shown as having one or more terminals 30 whereby the block is connected to one or more other blocks, and in a practical application of the invention, each block would have many more than three terminals. Lines 32 represent the connections that are required between the terminals of the block 14 and terminals of the other blocks, and lines 34 represent the connections that are required between the terminals of the block 15 and terminals of the other blocks. The blocks 14 and 15 are the same size and it is desired to determine whether interchanging these blocks will reduce the total wire length required to connect the blocks 14 . . . 28. It is, of course, possible that a connection might be required between two terminals of the same block, but this possibility is not illustrated in FIG. 2 because the wire length required to complete such a connection is not changed when the block is interchanged with another block. The possibility of a net having more than one terminal on a given block is ignored, because the resulting connection is simply a connection between two terminals on the same block.

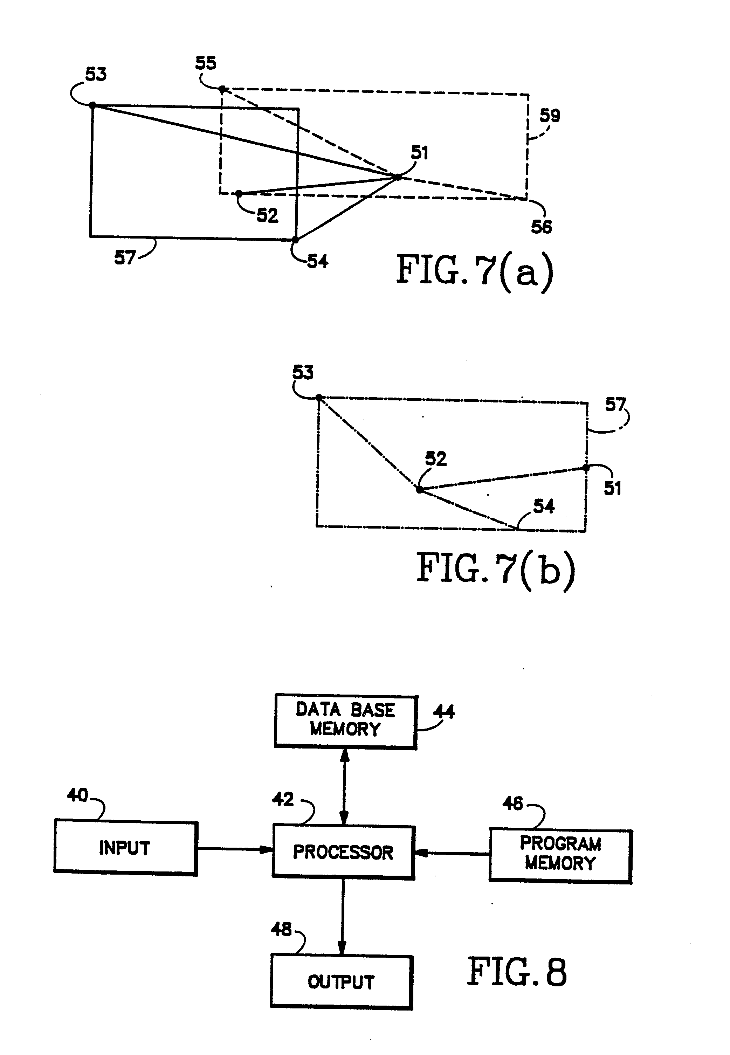

Data representing the nature of each block, the position of each block relative to the origin O of a rectangular Cartesian coordinate system (X, Y), the position of each terminal, and the connections between terminals is applied to a CAD system such as is shown in FIG. 8 by way of an input device 40 and is stored in a data base memory 44 of the CAD system.

As noted previously, it is impractical to determine the total wire length required if the interchange of the blocks 14 and 15 does not take place and compute the total wire length required if the interchange does take place. The net half-perimeter metric is used to provide an estimate as to whether the interchange would result in a reduction in the total wire length.

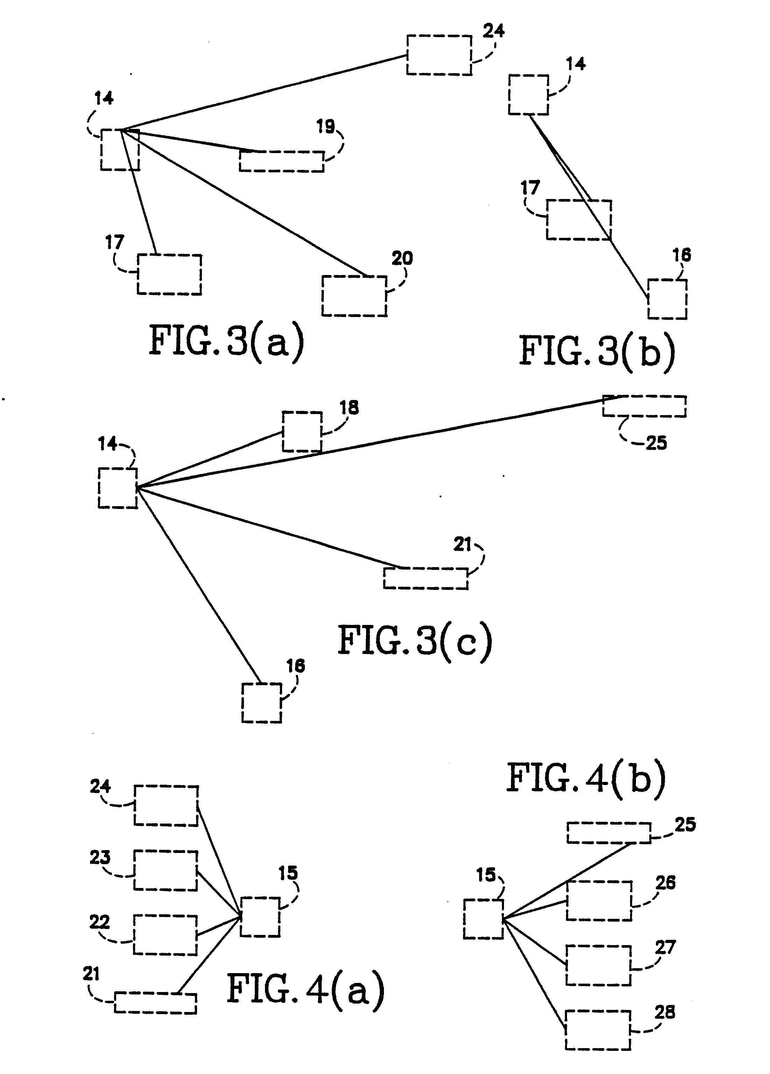

In order to compute the net half-perimeter, it is necessary first of all to identify the nets having terminals on each of the blocks 14 and 15. The nets having terminals on the block 14 are shown in FIG. 3 and the nets having terminals on the block 15 are shown in FIG. 4. The NHP for a particular net, such as the net shown in FIG. 3(c), is the sum of the vertical and horizontal extents of the smallest rectangle and has its sides parallel to the axes of the coordinate system (X, Y) and that contains all the terminals of the net.

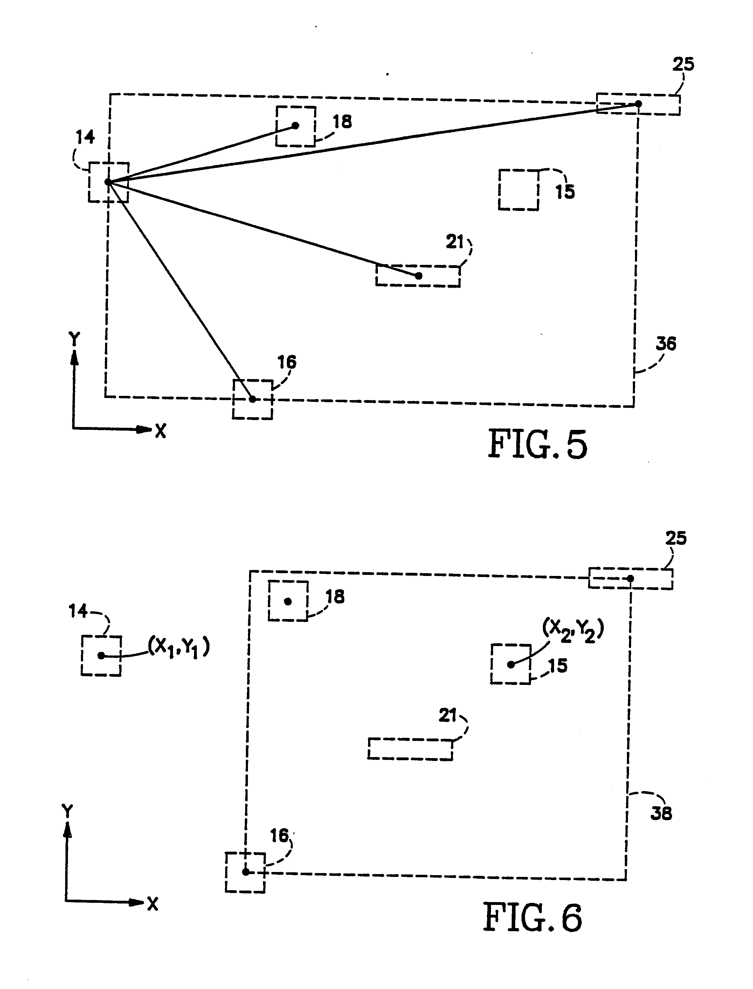

Having identified the nets that have terminals on the two potentially-interchangeable blocks 14 and 15, each terminal of a given block will be assumed to be at a common reference point of the block. The reference point is selected according to a rule which produces a unique result for the block, e.g. the center of the block. This is shown in FIG. 5 for the net illustrated in FIG. 3(c). The NHP for a given net will be assumed to be equal to the sum of the vertical and horizontal extents of the smallest rectangle that contains the reference points corresponding to all the terminals of the net. It will be appreciated that this is an approximation to the true NHP, but the approximation is justified because the extents of the blocks are generally small compared to the distances separating the blocks, and, in any event, the true NHP is only an approximation to the wire length required to complete a net.

The approximation regarding the positions of the terminals reduces the volume of data to be processed because it is not longer necessary to consider the location of each terminal of each block. It will be seen that if the interchange had been between the blocks 14 and 16 (which is the same size as the block 14), the size of the bounding rectangle 36 of the FIG. 5 net would not have changed, and therefore a second result of regarding each terminal of a block as being at a common reference point of the block, is that it is not necessary to determine the NHP for any net that has terminals on both of the blocks that are being considered for interchange. Consequently, it is necessary to evaluate, for a given net, only the effect of changing the position of one block on which that net has a terminal. For the net shown in FIG. 5 it is therefore necessary to consider only whether the NHP is reduced by moving the block 14 to the position of the block 15. This is accomplished by developing a data structure which relates the NHP to the position of one block on which the net has a terminal, the other blocks being considered stationary. In general, there are several such relations for any one block, one for each net with a terminal on that block. A subset of the blocks having terminals on the net being evaluated is established, such that the block being considered for interchange is excluded. A new rectangle 38 is defined which bounds the reference points of the blocks of the subset, and the half-perimeter of the new bounding rectangle and the coordinates of the center of that rectangle are determined. If the coordinates of the center of the new rectangle are (HZMID, VTMID) and the horizontal and vertical extents of the new rectangle are 2 X HZHALF and 2 X VTHALF respectively, then the NHP of a net including the block 14 is given by:

$$\text{MAX}(\text{HZHALF, ABS}(X-\text{HZMID})) + \text{HZHALF}$$
$$+ \text{MAX}(\text{VTHALF, ABS}(Y-\text{VTMID})) + \text{VTHALF}$$

where $(X_1, Y_1)$ are the coordinates of the reference point of the block 14. The change in the NHP when the block 14 is moved to the position $(X_2, Y_2)$ of the block 15 is:

$$\text{MAX}(\text{HZHALF, ABS}(X_1-\text{HZMID}) + \text{MAX }(\text{VTHALF, ABS}(Y_1-\text{VTMID})$$
$$-\text{MAX}(\text{HZHALF, ABS}(X_2-\text{HZMID}) - \text{MAX}(\text{VTHALF, ABS}(Y_2-\text{VTMID})$$

The quantity of interest is the change in the sum of the block NHPs for the blocks 14 and 15 when the two blocks are interchanged. This change, which is represented by DELNHP, can be computed by executing the following routine

```
DELNHP=0
FOR EACH NET CONNECTED TO BLOCK 14 DO
    GET HZHALF, VTHALF, HZMID, VTMID FOR NET
    DELNHP=DELNHP +
    MAX(HZHALF, ABS(X2-HZMID))
    - MAX(HZHALF, ABS(X1-HZMID))
    + MAX(VTHALF, ABS(Y2-VTMID))
    - MAX(VTHALF, ABS(Y1-VTMID))
ENDO NETS CONNECTED TO BLOCK 14
FOR EACH NET CONNECTED TO BLOCK 15 DO
    GET HZHALF, VTHALF, HZMID, VTMID FOR NET
    DELNHP=DELNHP +
    MAX (HZHALF, ABS(X1-HZMID))
    - MAX (HZHALF, ABS(X2-HZMID))
    + MAX (VTHALF, ABS(Y1-VTMID))
    - MAX (VTHALF, ABS(Y2-VTMID))
ENDO NETS CONNECTED TO BLOCK 15
```

If the final value of DELNHP is less than zero, the interchange is accepted, otherwise it is rejected and the next interchange is evaluated.

It will be understood that the values of HZHALF, VTHALF, HZMID and VTMID can all be derived from the coordinates of two diagonally opposite corners of the new bounding rectangle. Therefore it is only necessary to store and update, for each net having a terminal on each block, the coordinates of two points in order to enable computation of the change in sum of the block NHPs when two blocks are interchanged.

If one of the nets that had a terminal on the block 14 also had a terminal on the block 15, i.e. was a doubly-represented net, the interchange should not be evaluated for that net because it cannot result in a change in the NHP for the net. However, it is undesirable to have to check every net involved in every potential interchange for doubly-represented nets, because most potential interchanges will not have any doubly-represented nets.

This disadvantage is avoided by first ignoring the possibility of doubly-represented nets. If an improvement results, then the nets having terminals on the two blocks are examined to identify any doubly-represented nets, and if doubly-represented nets are identified, their illusory improvements are subtracted. If improvement still results, the interchange is accepted and if it does not it is rejected. By following this procedure, the extra processing to identify doubly-represented nets is required only for the small number of interchanges for which improvement is predicted. This result follows only because a doubly-represented net cannot result in an increase in the NHP.

This is illustrated in FIG. 7. A potential interchange between two blocks 51 and 52 is being evaluated. A first net, indicated by solid connecting lines in FIG. 7(a), has terminals on the blocks 51 . . . 54, and is therefore a doubly-represented net. The bounding rectangle 57 for the first net, omitting the block 51, is illustrated in solid lines in FIG. 7(a) and the bounding rectangle 58 for the first net without the block 52 is illustrated in dot-dashed lines in FIG. 7(b). A second net, indicated by dashed connecting lines in FIG. 7(a), has terminals on the blocks 51, 55 and 56 and the bounding rectangle 59 for the second net, again omitting the block 51, as illustrated in dashed lines. Since the blocks 51 and 52 are within the boundaries of the rectangles 59 and 58 respectively, the rectangles 59 and 58 are in fact the same size as the bounding rectangles for the entire second and first nets respectively. It will be assumed that no other nets are involved.

In accordance with the procedure outlined above, the change in NHPs for the first and second nets when the block 51 is moved to the position of the block 52 is computed, and the change in NHP for the first net when the block 52 is moved to the position of the block 51 is computed. The block 51 is outside the rectangle 57, and therefore the NHP for the first net decreases when the block 51 is moved to the position of the block 52. Because the block 52 is within the boundary of the rectangle 58, there is no change in the NHP for the second net when the block 51 is moved to the position of the block 52. On the other hand, the NHP for the first net is not changed when the block 52 is moved to the position of the block 51. Therefore, ignoring the fact that the first net is doubly-represented, the interchange of the blocks 51 and 52 results in a decrease in the placement NHP. Then, the existence of the doubly-represented net is identified and the illusory improvement is computed by determining the decrease in placement NHP that is attributable to the apparent decrease in the NHP for the first net on moving the block 51 to the position of the block 52. If this is less than the total decrease in placement NHP, it implies that the interchange resulted in a decrease in placement NHP even taking account of the doubly-represented net.

The method described above is carried out using the CAD system illustrated in FIG. 8. A program defining the method is stored in a program memory 46. A processor 42 operates under control of the program to execute the described method and update the data base files stored in the memory 44, and the updated data base files are made available by way of an output device 48. During a typical placement problem, with 1000 interchangeable blocks, say, the method will be performed about three million times.

It will be appreciated that the present invention is not restricted to the particular method and apparatus that have been described, and that variations may be made therein without departing from the scope of the invention as defined in the appended claims and equivalents thereof.

## Claims

1. A method of testing a placement of blocks at preselected positions on a carrier in order to determine whether the placement can be improved by interchanging a first block and a second block, the method comprising the following steps:

(a) selecting a terminal of the first block,

(b) identifying blocks that are connected to said terminal of the first block,

(c) computing a measure of the half-perimeter of a first geometrical figure bounding the positions on the carrier of the first block and the blocks identified in step (b), computing a measure of the half-perimeter of a second geometrical figure similar to the first geometrical figure and bounding the positions on the carrier of the second block and the blocks identified in step (b), and subtracting the half-perimeter of the second figure from the half-perimeter of the first figure to yield a difference value,

(d) carrying out steps (a), (b) and (c) for all other terminals, if any, of the first block and summing the difference values,

(e) carrying out steps (a), (b), (c) and (d) for the second block, and

(f) adding the sum yielded by step (d) to the sum yielded by step (e) to yield a test score and, if the test score is negative, modifying the placement by interchanging the first block and the second block.

2. A method according to claim 1, wherein step (a) comprises identifying a position on the carrier of the terminal selected in step (a), in step (c) the position of the first block is taken as the position identified in step (a), and in step (d) the positions of all other terminals of the first block are taken to be the position identified in step (a).

3. A method according to claim 2, wherein in step (f), if the test score is negative, the method further comprises determining whether a terminal of the first block is connected to a terminal of the second block and, if so, determining the amount of the test score that is attributable to terminals of the first and second blocks being connected, and if this amount is at least equal to the test score, not interchanging the first and second blocks, and otherwise interchanging the first and second blocks.

4. A method according to claim 1, wherein the positions of the blocks are defined by reference to a rectangular Cartesian coordinate system having first and second axes, and the first and second geometrical figures are rectangles having sides which are parallel to said first and second axes respectively.

5. A method according to claim 1, wherein step (c) is carried out by storing data representing a measure of the half-perimeter of a third geometrical figure similar to the first geometrical figure and bounding the positions on the carrier of the blocks identified in step (b) and using the stored data and data defining the position of the second block to provide the measure of the half-perimeter of the second geometrical figure.

6. A method according to claim 5, wherein the positions of the blocks are defined by reference to a rectangular Cartesian coordinate system having first and second axes, and the first and second geometrical figures are rectangles having sides which are parallel to said first and second axes respectively, and the stored data is data defining the positions of two diagonally opposite corners of the third geometrical figure.

7. A method of adjusting a placement of blocks on carrier, the placement being such that a plurality of the blocks can potentially be interchanged, comprising:

(a) identifying a pair of blocks that are potentially interchangeable and selecting one block of the pair as a first block and the other block of the pair as a second block,

(b) selecting a terminal of the first block,

(c) identifying blocks that are connected to said terminal of the first block,

(d) computing a measure of the half-perimeter of a first geometrical figure bounding the positions on the carrier of the first block and the blocks identified in step (c), computing a measure of the half-perimeter of a second geometrical figure similar to the first geometrical figure and bounding the positions on the carrier of the second block and the blocks identified in step (c), and subtracting the half-perimeter of the second figure from the half-perimeter of the first figure to yield a difference value,

(e) carrying out steps (b), (c) and (d) for all other terminals, if any, of the first block and summing the difference values,

(f) carrying out steps (b), (c), (d) and (e) for the second block,

(g) adding the sum yielded by step (e) to the sum yielded by step (f) to yield a test score and, if the test score is negative, modifying the placement by interchanging the first block and the second block,

(h) identifying another pair of blocks that are potentially interchangeable and selecting one block of the pair as a first block and the other block of the pair as a second block,

(i) repeating steps (b) - (g) for the pair of blocks identified in step (h), and

(j) repeating steps (h) and (i) for all remaining pairs of potentially interchangeable blocks.

8. A method of generating data representing the placement of functional blocks of an integrated circuit on an integrated circuit die, the method comprising the following steps:

(a) generating input data representing an initial placement of the functional blocks on the die, said input data comprising data defining the positions of the blocks on the die, data defining the positions of the terminals of the blocks and data defining the connections between terminals of the blocks,

(b) selecting first and second blocks for evaluation as to whether the blocks should be interchanged,

(c) selecting a terminal of the first block,

(d) identifying blocks that are connected to said terminal of the first block,

(e) computing a measure of the half-perimeter of a first geometrical figure bounding the positions on the die of the first block and the blocks identified in step (d), computing a measure of the half-perimeter of a second geometrical figure similar to the first geometrical figure and bounding the positions on the die of the second block and the blocks identified in step (d), and subtracting the perimeter of the second figure from the half-perimeter of the first figure to yield a difference value,

(f) carrying out steps (c), (d), (e) and (f) for all other terminals, if any, of the first block and summing the difference values,

(g) carrying out steps (c), (d), (e) and (f) for the second block, and

(h) adding the sum yielded by step (f) to the sum yielded by step (g) to yield a test score and, if the test score is negative, modifying the input data by interchanging the position of the first block and the position of the second block.

9. A method according to claim 8, wherein step (c) comprises identifying a position on the carrier of the terminal selected in step (c), in step (e) the position of the first block is taken as the position identified in step (c), and in step (f) the positions of all other terminals of the first block are taken to be the position identified in step (c).

10. A method according to claim 9, wherein in step (h), if the test score is negative, the method further comprises determining whether a terminal of the first block is connected to a terminal of the second block and, if so, determining the amount of the test score that is attributable to terminals of the first and second blocks being connected, and if this amount is at least equal to the test score, not interchanging the first and second blocks, and otherwise interchanging the first and second blocks.

11. A method according to claim 8, wherein the positions of the blocks are defined by reference to a rectangular Cartesian coordinate system having first and second axes, and the first and second geometrical figures are rectangles having sides that are parallel to said first and second axes respectively.

12. A method according to claim 8, further comprising using the modified data in fabrication of an integrated circuit.

13. An integrated circuit fabricated in accordance with a design procedure comprising the steps of:

(a) defining a placement of circuit blocks at preselected positions on a substrate,

(b) testing the placement in order to determine whether the placement can be improved by interchanging a first block and a second block by

i. selecting a terminal of the first block,

ii. identifying blocks that are connected to said terminal of the first block,

iii. computing a measure of the half-perimeter of a first geometrical figure bounding the positions on the carrier of the first block and the blocks identified in step ii, computing a measure of the half-perimeter of a second geometrical figure similar to the first geometrical figure and bounding the positions on the carrier of the second block and the blocks identified in step ii, and subtracting the half-perimeter of the second figure from the half-perimeter of the first figure to yield a difference value,

iv. carrying out the steps i, ii and iii for all other terminals, if any, of the first block and summing the difference values,

v. carrying out steps i, ii, iii and iv for the second block, and

vi. adding the sum yielded by step iv to the sum yielded by step v to yield a test score, and

(c) if the test score is negative, modifying the placement by interchanging the first block and the second block.

14. Apparatus for testing an initial placement of blocks on a carrier in order to determine whether the placement can be improved by interchanging a first block and a second block, comprising:

input means for receiving input data representing the initial placement, the input data comprising data defining the positions of the blocks, data defining the positions of the terminals of the blocks, and data defining the connections between the terminals of the blocks,

a first memory for storing said input data,

a second memory storing a placement improvement program,

processor means for operating upon the input data stored in the first memory in accordance with the program stored in the second memory, and thereby modifying the input data, and

output means for providing the modified data,

wherein the program stored in the second memory is such as to cause the processor to execute the following operations,

(a) select a terminal of the first block,

(b) identify blocks that are connected to said terminal of the first block,

(c) compute a measure of the half-perimeter of a first geometrical figure bounding the positions on the carrier of the first block and the blocks identified in step (b), compute a measure of the half-perimeter of a second geometrical figure similar to the first geometrical figure and bounding the positions on the carrier of the second block and the blocks identified in step (b), and subtract the half-perimeter of the second figure from the half-perimeter of the first figure to yield a difference value,

(d) carry out steps (a). (b) and (c) for all other terminals, if any, of the first block and sum the difference values,

(e) carry out steps (a), (b), (c) and (d) for the second block, and

(f) add the sum yielded by step (d) to the sum yielded by step (e) to yield a test score and, if the test score is negative, modifying the input data by interchanging the position of the first block and the position of the second block.

FIG.1

FIG.2

**FIG.3(a)**

**FIG.3(b)**

**FIG.3(c)**

**FIG.4(b)**

**FIG.4(a)**

FIG.5

FIG.6

FIG.7(a)

FIG.7(b)

FIG.8